# EUROPEAN PATENT SPECIFICATION

(11) **EP 1 480 305 B1**
(45) Date of publication and mention of the grant of the patent: **31.05.2006**
(21) Application number: 04009317.1
(22) Date of filing: 20.04.2004
(51) Int. Cl.: H01S 5/50, H04B 10/17, H01S 3/06

(54) **Semiconductor optical amplifier module**
Optisches Halbleiterverstärker-Modul
Module amplificateur optique à semiconducteur

(30) Priority: 21.05.2003 KR 2003032239
(43) Date of publication of application: 24.11.2004
(73) Proprietor: SAMSUNG ELECTRONICS CO., LTD., Suwon-si, Gyeonggi-do (KR)
(72) Inventor: Yun, In-Kuk, Yeongtong-gu Suwon-si Gyeonggi-do (KR); Lee, Jeong-Seok, Yeongtong-gu Suwon-si Gyeonggi-do (KR)
(74) Representative: Grünecker, Kinkeldey, Stockmair & Schwanhäusser Anwaltssozietät

(56) References cited:
- EP-A- 0 812 078
- US-A- 5 202 791
- TIEMEIJER L F ET AL: "HIGH-GAIN 1310 NM SEMICONDUCTOR OPTICAL AMPLIFIER MODULES WITH A BUILT-IN AMPLIFIED SIGNAL MONITOR FOR OPTICAL GAIN CONTROL" IEEE PHOTONICS TECHNOLOGY LETTERS, IEEE INC. NEW YORK, US, vol. 9, no. 3, 1 March 1997 (1997-03-01), pages 309-311, XP000684398 ISSN: 1041-1135
- PATENT ABSTRACTS OF JAPAN vol. 2000, no. 11, 3 January 2001 (2001-01-03) & JP 2000 223762 A (HITACHI CABLE LTD), 11 August 2000 (2000-08-11)

## Description

### BACKGROUND OF THE INVENTION

### 1. Field of the Invention

The present invention relates to a semiconductor optical element, and more particularly to a semiconductor optical amplifier module for amplifying an optical signal entering the semiconductor optical element.

### 2. Description of the Related Art

In typical use are a variety of optical amplifiers for optical communication, one example being an optical fiber amplifier doped with any one of a several rare earth ions, such erbium ions and thulium ions. Such optical fiber amplifiers require that the rare earth ions be pumped to them with a pumping light so that the amplifier can amplify its own received optical signal.

The semiconductor optical amplifier includes a plurality of layers deposited on a semiconductor substrate, i.e., an activation layer having a multi-quantum well, a waveguide layer serving as an I/O (Input/Output) medium, a clad layer surrounding the waveguide layer, an upper electrode layer, and a lower electrode layer.

Too high an amplification factor for the semiconductor optical amplifier may harm other optical elements connected to the semiconductor optical amplifier and/or may deteriorate the amplifier's optical signal as evidenced by a low SNR (Signal-to-Noise Ratio). Such SNR characteristics indicate a ratio of signal power contained in an optical signal, present in either a general transmission/reception device (e.g., a receiver or an amplifier) or an optical communication system, to noise power. The SNR characteristics serve as an index for indicating the ratio of an optical signal to noise. The optical signal power is denoted by "S", and the noise power is denoted by "N".

Maintaining a fixed ratio of entry optical signal to amplified optical signal, i.e., a fixed amplification factor, is very critical to the optimal performance of the semiconductor optical amplifier. A semiconductor optical amplifier module includes a light-receiving element for monitoring the power level of an I/O optical signal, and a controller for comparing a power level of the optical signal detected by the light-receiving element with a prescribed power level and for maintaining a prescribed, constant amplification gain.

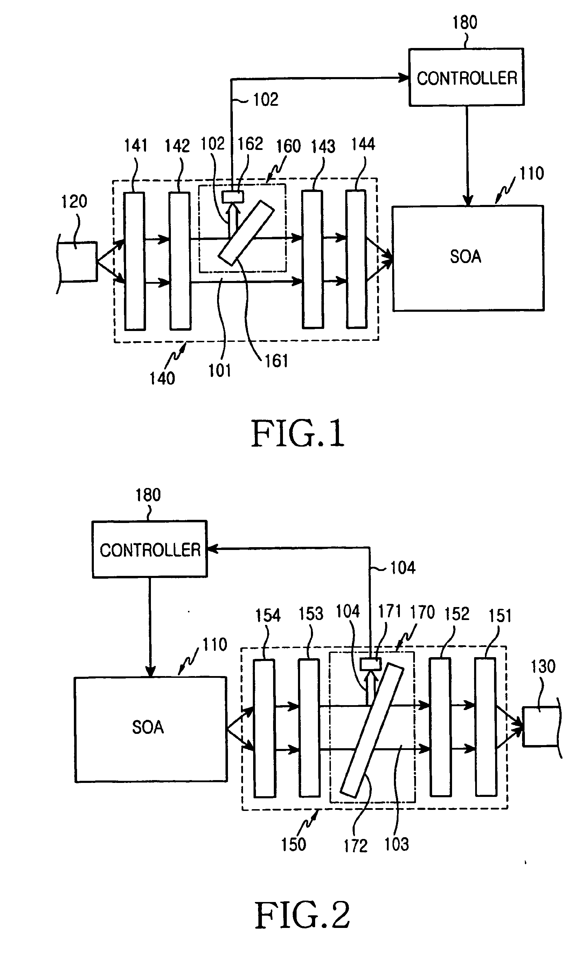

Figures 1 and 2 depict a conventional optical amplifier module. The conventional optical amplifier module includes a semiconductor optical amplifier (SOA) 110, an input unit 140 containing a first detector 160, an output unit 150 containing a second detector 170, input and output optical fibers 120 and 130, and a controller 180.

One end of the SOA 110 faces the input unit 140 while the other end faces the output unit 150. the SOA 110 amplifies an optical signal 101 applied from the input optical fiber 120 to the input unit 140, and outputs the amplified optical signal 103 to the output unit 150.

The input unit 140 includes a first collimating lens system 141 for collimating the optical signal 101 received from the input optical fiber 120, a first glass window 142, a first convergence lens system 144 for converging an optical signal collimated by the first glass window 142 at one end of the SOA 110, a first isolator 143 disposed between the first glass window 12 and the first convergence lens system 144, and a first detector 160 disposed between the first glass window 142 and the first isolator 143. The input unit 140 serves as a signal combiner for converging onto the SOA 110 the optical signal 101 received from the input optical fiber 120.

The first collimating lens system 141 collimates the optical signal 101 received from the input optical fiber 120 therein. The first glass window 142 transmits an optical signal collimated at the first collimating lens system 141 to the first isolator 143, and is disposed between the first collimating lens system 141 and the first detector 160.

The first isolator 143 transmits the optical signal it receives from the first glass 142 headed toward the first collimating lens system 144, and cuts off an optical signal transmitted back from the first convergence lens system 144 toward the first detector 160.

The first convergence lens system 144 converges the optical signal generated by the first isolator 143 onto one end of the semiconductor optical amplifier 110.

The first detector 160, disposed between the first glass window 142 and the first isolator 143, includes a reflector161 for partially reflecting the optical signal transferred from the first glass window 142 to the first isolator 143 perpendicular to a traveling path of the optical signal, and a first monitor photo-diode 162 for detecting a power level of the optical signal 102 reflected from the reflector161. The first detector 160 is adapted to monitor an amplification gain of the optical signal 103 amplified by the SOA 110, and detects a power level of the optical signal 101 applied to the SOA 110.

The output unit 150 is a combiner for collecting the optical signal 103 amplified by the SOA 110 in the output optical fiber 130 with minimum transfer loss. The output unit 150 includes a second convergence lens system 154 for collimating the optical signal 103 received from the SOA 110, a second isolator 153, a second convergence lens system 151 for converging the amplified optical signal 103 onto one end of the output optical fiber 130, a second glass window 152 for transmitting the amplified optical signal 103 to the second convergence lens system 151, and a second detector 170 disposed between the second isolator 153 and the second glass window 152.

The second detector 170 includes an beam splitter 172 for dividing a power level of the amplified optical signal 103 traveling from the second isolator 153 to the second glass window 152, and a second monitor photo-diode 171 for detecting a power level of the optical signal 104 divided by the beam splitter 172.

The controller 180 receives the power level of the optical signal 102 from the first detector 160 and the power level of the power signal 104 from the second detector 170, and compares the power level of the optical signal 102 applied to the SOA 110 with the power level of the optical signal 104 amplified by the SOA 110 to recognize an amplification gain of the SOA 110. The controller 180 compares the power levels of the optical signals 102, 104 detected by the first and second detectors 160, 170, and outputs a control signal to the SOA 110 to maintain a constant, prescribed amplification gain.

The output optical fiber 130 outputs outside the SOA module a reception optical signal converging on one end of the fiber 130 by means of the second convergence lens system 151 of the output unit 150.

However, the conventional SOA module adapts a plurality of detectors each having either a high-priced power divider or a mirror to detect a power level of its own reception optical signal and a power level of an amplified optical signal, resulting in an increased number of fabrication steps and increased production costs. Therefore, the conventional SOA module decreases coupling efficiency between the SOA and an input unit along with coupling efficiency between the output unit and the output optical fiber, resulting in an increased noise factor of the SOA and a reduced saturation output power. A SOA module with a built-in amplified signal monitor is disclosed in Tiemeijer et al., IEEE Photomics Letters, 9(1997) 3, Pages 309-311.

### SUMMARY OF THE INVENTION

Therefore, the present invention has been made in view of the above problems, and, in an aspect of the present invention, an SOA (Semiconductor Optical Amplifier) module monitors an amplification gain of an amplified optical signal without causing deterioration of the coupling efficiency.

In accordance with the present invention was defined in claim 1, the above and other aspects can be accomplished by the provision of a semiconductor optical amplifier (SOA) module apparatus that includes a semiconductor optical amplifier (SOA) for amplifying an optical signal applied to its own first stage, outputting the amplified optical signal at its own second stage, and outputting an ASE (Amplified Spontaneous Emission) light at the first stage. The module further includes an input unit having a first isolator which transmits an input optical signal to the first stage of the SOA, controls the ASE light received from the first stage of the SOA to separate it from a traveling path of the input optical signal at a prescribed angle, and transmits the ASE light separated from the traveling path. A first monitor photo-diode with its own light-receiving surface oriented perpendicular to a traveling path of the ASE light emitted from the first isolator detects a power level of the ASE light. An output unit outputs the amplified optical signal received from the second stage of the SOA to the outside, and outputs a partially-uncoupled optical signal created therein for reception by a second monitor photo-diode for detecting an uncoupled optical signal emitted from the output unit.

### BRIEF DESCRIPTION OF THE DRAWINGS

The above and other aspects, features and other advantages of the present invention will be more clearly understood from the following detailed description taken in conjunction with the accompanying drawings, in which the same or similar features are annotated with identical or analogous numerals throughout the several views:
Fig. 1 is a block diagram of detecting a power of an optical signal applied to a conventional SOA module;
Fig. 2 is a block diagram of detecting a power of an optical signal outputted from a conventional SOA module;
Fig. 3 is a block diagram of a SOA module in accordance with a first preferred embodiment of the present invention;
Fig. 4 is a block diagram of a SOA module in accordance with a second preferred embodiment of the present invention;
Fig. 5a is a graph illustrating a relationship between a power level of an optical signal applied to a SOA shown in Fig. 2 and a power level of an amplified spontaneous emission (ASE) light created at the first stage of the SOA; and
Fig. 5b is a graph illustrating a relationship between a power level of an uncoupled optical signal emitted from an output unit of the SOA and a power level of an output signal amplified by the SOA.

### DETAILED DESCRIPTION OF THE PREFERRED EMBODIMENTS

Preferred embodiments of the present invention will be described in detail with reference to the annexed drawings. In the following description, detailed description of known functions and configurations incorporated herein will be omitted for clarity of presentation.

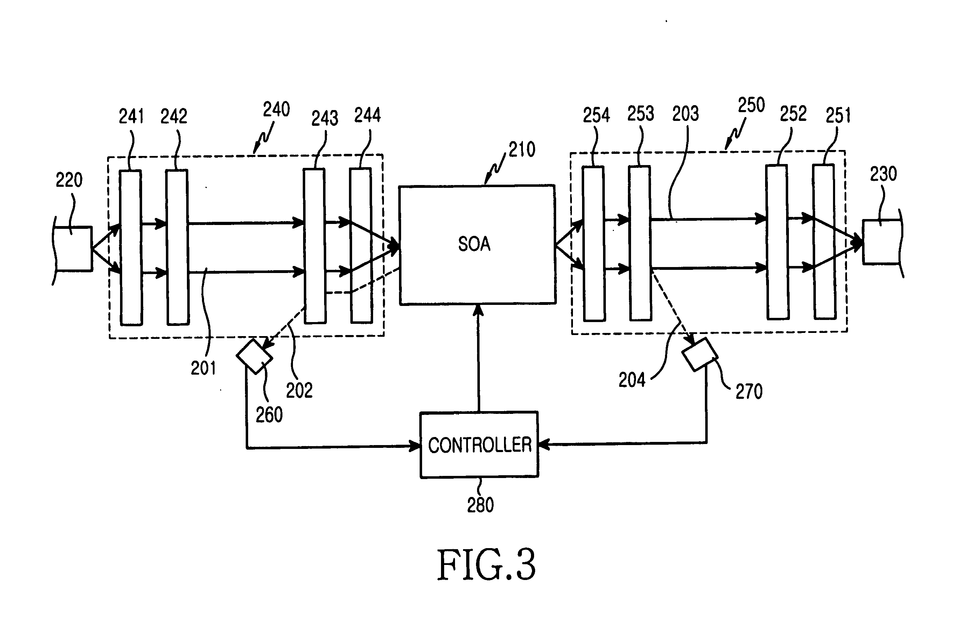

Fig. 3 is a block diagram depicting, by way of non-limitative example, an SOA module in accordance with a first preferred embodiment of the present invention. The SOA module includes an input optical fiber 220, an output optical fiber 230, a SOA 210 for amplifying a received optical signal, an input unit 240 for transmitting an optical signal 201 received from the input optical fiber 220 to one end of the SOA 210, a first monitor photo-diode 260, an output unit 250 for converging an optical signal 203 amplified by the SOA 210 onto one end of the output optical fiber 230, a second monitor photo-diode 270, and a controller 280 for controlling an amplification gain of the optical signal 203 amplified by the SOA 210.

The input optical fiber 220 transmits an optical signal to be amplified to the SOA module, and the output optical fiber 230 outputs the optical signal 203 amplified by the SOA 210 to the outside of the SOA module.

The SOA 210 amplifies an applied optical signal 201 at its own first stage, and outputs the amplified optical signal 203 at its second stage. A lower clad layer, an activation layer, and an upper clad layer are sequentially deposited on a semiconductor substrate of the SOA 210. A window layer for restricting a current applied to the activation layer may be deposited on both ends of a ridge stripe disposed at the center of the resultant layer on which the lower clad layer, the activation layer, and the upper clad layer are sequentially deposited. A cap layer may be deposited on the uppermost layer of the SOA. If the input light passes through the activation layer of the SOA 210, the output light of the SOA 210 is amplified by an amplification gain of the activation layer.

The SOA 210 has a configuration similar to that of a semiconductor laser device. However, in contrast to the semiconductor laser device, the SOA 210 deposits an antireflective coating layer on both ends of a cleaved region in such a way that a traveling-wave-type SOA is formed. The SOA 210 outputs the ASE light 202 created therein while amplifying an optical signal through one of its ends serving to receive the optical signal to be amplified.

The input unit 240 includes a first isolator 243, a first collimating lens system 241 for collimating an input optical signal 201, a first glass window 242 for transmitting the collimated optical signal to the first isolator 243, and a first convergence lens system 244 disposed between the first isolator 243 and the SOA 210. The input unit 240 serves as a combiner for coupling the optical signal 201 received from the input optical fiber 220 with one end of the SOA 210.

The first collimating lens system 241 faces one end of the input optical fiber 220, and collimates the optical signal 201. The first glass window 242 is disposed between the first collimating lens system 241 and the first isolator 243, and transmits the optical signal collimated at the first collimating lens system 241 to the first isolator 243.

The first convergence lens system 244, disposed between the first isolator 243 and the SOA 210, converges the optical signal received from the first isolator 243 onto a first stage of the SOA 210, and outputs the ASE light 202 emitted from the first stage of the SOA 210 to the first isolator 243.

The first isolator 243 transmits the optical signal received from the first glass window 242 to the first convergence lens system 244, controls the ASE light 202 received from the SOA 210 to separate it from a traveling path of the optical signal collimated at the first collimating lens system 241 at a prescribed angle to the traveling path, and transmits the ASE light 202 separated from the traveling path. An isolator independent of a polarized light may be adapted as such a first isolator 243, and is made of a birefringence material.

The first monitor photo-diode 260 is arranged at one end of the input unit 240 to detect a power level of the ASE light 202 received from the first isolator 243, and outputs the detected power level of the ASE light 202 to the controller 280. For this purpose, the first monitor photo-diode 260 is arranged to allow its activation layer (not shown) to be perpendicular to the traveling path of the ASE light 202.

The output unit 250 serves as a combiner for converging the optical signal 203 amplified by the SOA 210 onto one end of the output optical fiber 230. The output unit 250 includes a second collimating lens system 254 for collimating the optical signal 203 amplified by the SOA 210, a second isolator 253 for transmitting the optical signal collimated at the second collimating lens system 254, a second convergence lens system 251 for converging the optical signal 203 amplified by the SOA 210 onto one end of the output optical fiber 230, and a second glass window 252 disposed between the second isolator 253 and the second convergence lens system 251.

The second collimating lens system 254 faces a second stage of the SOA 210, and collimates the optical signal 203 amplified by the SOA 210.

The second isolator 253 transmits the optical signal collimated at the second collimating lens system 254, controls a partially-uncoupled optical signal 204 to separate it from a traveling path of the optical signal collimated at the second collimating lens system 254 at a prescribed angle to the traveling path, and transmits the uncoupled optical signal 204 separated from the traveling path. The uncoupled optical signal 204 is emitted at a prescribed angle while traveling through the second isolator 253, the optical signal having escaped from the traveling path of the collimated optical signal. An isolator independent of a polarized light may be adapted as such a second isolator 253.

The second glass window 252 is disposed between the second isolator 253 and the second convergence lens system 251, and transmits the collimated optical signal received from the second isolator 253 to the second convergence lens system 251. The second convergence lens system 251 is disposed between the second glass window 252 and one end of the output optical fiber 230, and converges the optical signal received from the second glass window 252 onto one end of the output optical fiber 230.

Specifically, the output unit 250 converges the optical signal 203 amplified by the SOA 210 onto one end of the output optical fiber 230, and outputs a partially-uncoupled optical signal 204, which, due to reflection or dispersion, escapes from a traveling path of the amplified optical signal 203 toward the output optical fiber.

The second monitor photo-diode 270 detects the uncoupled optical signal 204 created from the second isolator 253 of the output unit 250, and outputs a power level of the uncoupled optical signal 204 to the controller 280. An activation layer (not shown) of the second monitor photo-diode 270 is arranged to be perpendicular to a traveling path of the uncoupled optical signal 204. Specifically, due to reflection or dispersion to create the uncoupled optical signal, its path is diverted away from the output optical fiber 230 and toward the second monitor photo-diode 270 which has been disposed to receive the signal.

The controller 280 compares a power level of the ASE light 202 detected by the first monitor photo-diode 260 with a power level of the uncoupled optical signal 204 detected by the second monitor photo-diode 270, and calculates an amplified gain of the optical signal 203 amplified by the SOA 210. The controller 280 compares a real amplification gain of the SOA 210 with a prescribed amplification gain to be maintained at the SOA 210, and outputs a control signal for allowing the SOA 210 to constantly maintain a prescribed stable amplification gain to the SOA 210.

Fig. 5a depicts a graph illustrating, by way of example and based on exemplary experimental data, a relationship between a power level of an optical signal applied to the SOA 210 shown in Fig. 2 and a power level of an amplified spontaneous emission (ASE) light created from a first stage of the SOA 210. The X-axis (Pin) denotes the power level of the optical signal 201 applied to the SOA 210, the left Y-axis (Pout) denotes a power level of the optical signal 203 amplified by the SOA 210, and the right Y-axis (MPDin) denotes a power level of the ASE light 202 detected by the first monitor photo-diode 260 disposed at one side of the input unit 240. As seen from the graph, the power level of the ASE light 202 detected by the first monitor photo-diode 260 is inverse-proportional to the power level of the optical signal 201 applied to the SOA 210.

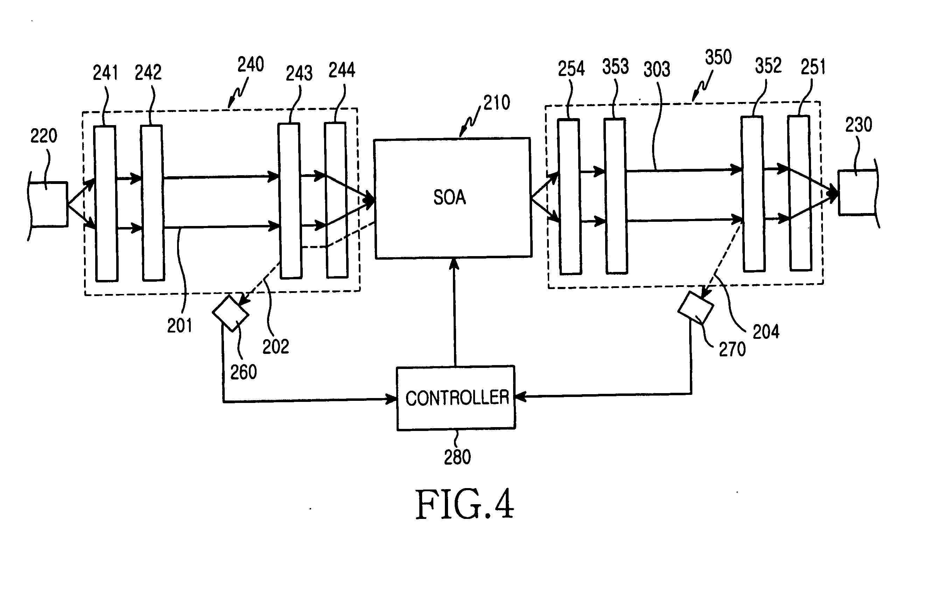

The box indicated by dotted lines in Fig. 4a denotes an effective detection range 400 for detecting a power level of the optical signal 201 applied to the input unit 240 upon receiving a power level of the ASE light 202 detected by the first monitor photo-diode 260. The effective detection range 400 denotes a prescribed zone wherein the power level of the ASE light 202 detected by the first monitor photo-diode 260 is inversely proportional to the power level of the optical signal 201 applied to the input unit 240. The amplified optical signal readings outside the range 400 represent power levels higher than inverse proportionality would suggest. The effective detection range 400 is therefore confined to 0.0 ~ 0.6 mW, as shown.

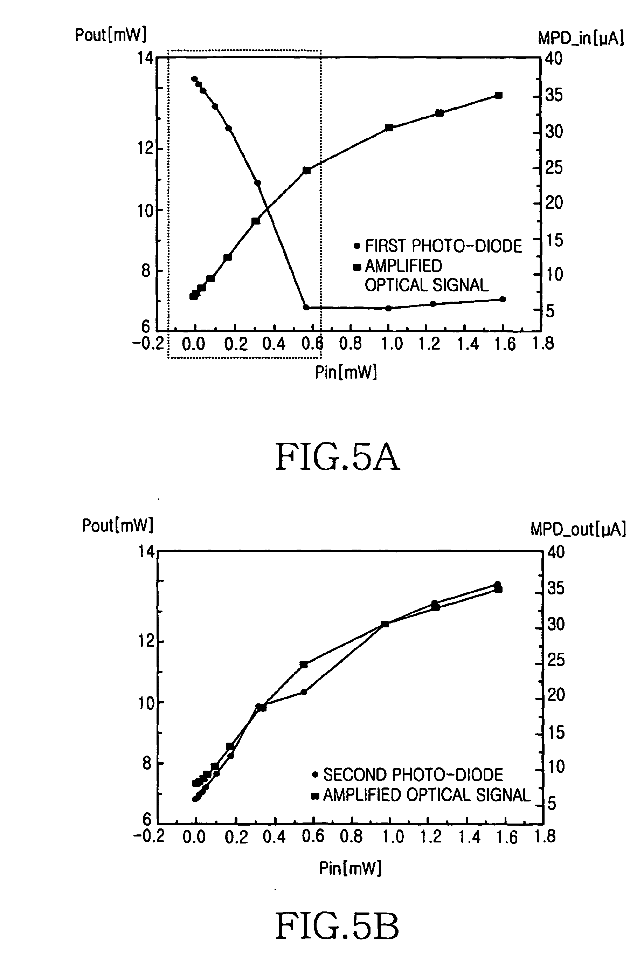

Fig. 5b depicts a graph illustrating a relationship between a power level of an uncoupled optical signal emitted from the output unit of the SOA 210 shown in Fig. 2 and a power level of an output signal amplified by the SOA 210. The X-axis (Pin) denotes a power level of the optical signal 201 applied to the SOA 210, the left Y-axis (Pout) denotes a power level of the optical signal 203 amplified by the SOA 210, and the right Y-axis (MPDout) denotes a power level of the uncoupled optical signal 204 detected by the second monitor photo-diode 270 disposed at one side of the output unit 250. As can be seen from the graph, the power level of a partially-uncoupled optical signal 204 created from the output unit 250 varies linearly with the power level of the optical signal 203 amplified by the SOA 210.

Fig. 4 is a block diagram showing a possible embodiment for an SOA module in accordance with a second preferred embodiment of the present invention. As in the first embodiment, the output unit 250 creates a partially-uncoupled signal 204 by diverting the optical signal 203 from its traveling path and at a prescribed angle toward the second photo-detector 270. This second embodiment differs from the first embodiment, however, in that it is the second glass window, rather than the second isolator, which partially uncouples the optical signal 204, and in that the separation in the second embodiment is by means of reflection. Accordingly, in the second embodiment, the amplified optical signal 303 is transmitted by the second isolator 353 to the second glass window 352, and it is the second glass window 352 that creates the partially-uncoupled signal 204. As apparent from the above description, the SOA module according to the present invention detects a power level of a reflection or uncoupled optical signal created from either an isolator or a prescribed module such as a glass window, such that it is not affected by the coupling efficiency of I/O optical signals, and at the same time detects an amplification gain of an optical signal amplified by the SOA, resulting in a minimal noise factor and a minimal saturation output power.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. A semiconductor optical amplifier (210) module apparatus for amplifying an optical signal (201) received from an input optical fiber (220), and transmitting the amplified optical signal (203) to an output optical fiber (230), comprising:
a semiconductor optical amplifier (210) for amplifying an optical signal (201) applied to its own first stage, outputting the amplified optical signal (203) at its own second stage, and outputting an Amplified Spontaneous Emission light (202) at the first stage;
an input unit (240);
a first monitor photo-diode (260) for receiving, and detecting a power level of, the Amplified Spontaneous Emission light (202) passing through the first isolator (243);
an output unit (250) for converging the amplified optical signal (203) received from the semiconductor optical amplifier (210) onto one end of the output optical fiber (230);
a second monitor photo-diode (270) for detecting an optical signal (204) uncoupled from the amplified optical signal (203); and
a controller (280) receiving signals from the photo diodes (260, 270) and generating a control signal for the semiconductor **optical amplifier (210),**
**characterized in that**
said input unit (240) having a first isolator (243) which transmits an input optical signal (201) to the first stage of the semiconductor optical amplifier (210), controls the Amplified Spontaneous Emission light (202) received from the first stage of the semiconductor optical amplifier (210) to separate it from a traveling path of the input optical signal (201) at a prescribed angle, and transmits the Amplified Spontaneous Emission light (202) separated from the traveling path.

2. The apparatus as set forth in claim 1, wherein the input unit (240) includes:
a first collimating lens system (241) for facing one end of the input optical fiber (220), and collimating the optical signal;
a first glass window (242) for transmitting to the first isolator (243) the optical signal collimated at the first collimating lens system (241); and
a first convergence lens system (244), disposed between the first isolator (243) and the first stage of the semiconductor optical amplifier (210), for converging the optical signal received from the first isolator (243) onto the first stage of the semiconductor optical amplifier (210), and outputting to the first isolator (243) the Amplified Spontaneous Emission light (202) emitted from the first stage of the semiconductor optical amplifier (210).

3. The apparatus as set forth in claim 1 or 2, wherein said controller (280) is communicatively connected with the first monitor photo-diode (260) and configured for determining a power level of the optical signal as a function of the detected power level of the Amplified Spontaneous Emission light (202).

4. The apparatus as set forth in claim 1, 2 or 3, wherein:
said second monitor photo-diode (270) detecting an uncoupled optical signal (204) which is emitted from the output unit (250) without being transmitted to the one end of the output optical fiber (230).

5. The apparatus as set forth in claim 1 or 2, wherein the output unit (250) includes:
a second collimating lens system (254) for collimating the amplified optical signal received from the second stage of the semiconductor optical amplifier (210);
a second isolator (253) for transmitting the amplified optical signal received from the second collimating lens system (254), controlling a partially-uncoupled optical signal (204) to separate it from a traveling path of the amplified optical signal at a prescribed angle, and transmitting the uncoupled optical signal (204) separated from the traveling path;
a second convergence lens system (251) disposed for converging the amplified optical signal (203) received from the second isolator (253) onto one end of the output optical fiber (230); and
a second glass window (252) disposed between the second isolator (253) and the second convergence lens system (252) for transmitting the collimated amplified optical signal to the second convergence lens system (251).

6. The apparatus as set forth in claim 1 or 2, wherein the output unit includes:
a second collimating lens system (254) for collimating the amplified optical signal received from the second stage of the semiconductor optical amplifier (210);
a second convergence lens system (251) for converging the amplified optical signal (203) collimated by the second collimating lens system (254) onto one end of the output optical fiber (230);
a second isolator (253) disposed between the second collimating lens system (254) and the second convergence lens system (251) for transmitting the amplified optical signal received from the second collimating lens system (254) to the second convergence lens system (251), and cutting off optical signals received from the second convergence lens system (251); and
a second glass window (252) disposed between the second isolator (253) and the second convergence lens system (251), for transmitting the amplified optical signal received from the second isolator (253) to the second convergence lens system (251), and reflecting a partially-uncoupled optical signal (204) to separate it from the traveling path of the amplified optical signal at a prescribed angle.

7. The apparatus as set forth in claim 5 or 6, wherein said second monitor photo-diode (270) receiving and detecting a power level of the separated partially-uncoupled optical signal (204).

8. The apparatus as set forth in claim 7, wherein said controller (280) communicatively connected with the second monitor photo-diode (270) and configured for determining a power level of the amplified optical signal received from the second stage of the semiconductor optical amplifier (210) based on the detected power level of the separated partially-coupled optical signal (204).

9. The apparatus as set forth in claim 8, wherein the controller (210) is configured for determining, as a function of the detected power level of the Amplified Spontaneous Emission light (202), a power level of the optical signal before amplification by the semiconductor optical amplifier (210).

10. The apparatus as set forth in any one of the previous claims, wherein the apparatus is configured to perform the separating of the optical signal by refracting the optical signal.

11. The apparatus as set forth in claims 3, 4, 8, 9 or 10,wherein the controller (280) is in communicative connection with the first monitor photo-diode (260), the output unit (250) and the semiconductor optical amplifier (210) and is configured for regulating a level of amplification of the semiconductor optical amplifier (210).

## Patentansprüche

1. Modulvorrichtung eines optischen Halbleiterverstärkers (210) zum Verstärken eines optischen Signals (201), das über eine Eingangs-Lichtleitfaser (220) empfangen wird, und zum Senden des verstärkten optischen Signals (203) zu einer Ausgangs-Lichtleitfaser (230), wobei sie umfasst:
einen optischen Halbleiterverstärker (210), der ein an seine eigene erste Stufe angelegtes optisches Signal (201) verstärkt, das verstärkte optische Signal (203) an seiner eigenen zweiten Stufe ausgibt und an der ersten Stufe ein verstärktes Spöntanemissions-Licht (202) ausgibt;
eine Eingangseinheit (240);
eine erste Überwachungs-Fotodiode (260), die das verstärkte Spontanemissions-Licht (202), das durch den ersten Isolator (243) hindurchtritt, empfängt und einen Leistungspegel desselben erfasst;
eine Ausgangseinheit (250), die das von dem optischen Halbleiterverstärker (210) empfangene verstärkte optische Signal (203) auf ein Ende der Ausgangs-Lichtleitfaser (230) bündelt;
eine zweite Überwächungs-Fotodiode (270), die ein aus dem verstärkten optischen Signal (203) ausgekoppeltes optisches Signal (204) erfasst; und
eine Steuereinrichtung (280), die Signale von den Fotodioden (260, 270) empfängt und ein Steuersignal für den optischen Halbleiterverstärker (210) erzeugt,
**dadurch gekennzeichnet, dass**
die Eingangseinheit (240) einen ersten Isolator (243) aufweist, der ein optisches Eingangssignal (201) zu der ersten Stufe des optischen Halbleiterverstärkers (210) durchlässt, das von der ersten Stufe des optischen Halbleiterverstärkers (210) empfangene verstärkte Spontanemissions-Licht (202) steuert, um es um einem vorgeschriebenen Winkel von einem Laufweg des optischen Eingangssignals (201) zu trennen, und das von dem Laufweg getrennte verstärkte Spontanemissions-Licht (202) durchlässt.

2. Vorrichtung nach Anspruch 1, wobei die Eingangseinheit (240) enthält:
ein erstes Kollimationslinsensystem (241), das einem Ende der Eingangs-Lichtleitfaser (220) zugewandt ist und das optische Signal kollimiert;
ein erstes Glasfenster (242), das das an dem ersten Kollimationslinsensystem (241) kollimierte optische Signal zu dem ersten Isolator (243) durrhlässt; und
ein erstes Sammellinsensystem (244), das zwischen dem ersten Isolator (243) und der ersten Stufe des optischen Halbleiterverstärkers (210) angeordnet ist, um das von dem ersten Isolator (243) empfangene optische Signal auf die erste Stufe des optischen Halbleiterverstärkers (210) zu bündeln und das von der ersten Stufe des optischen Halbleiterverstärkers (210) emittierte verstärkte Spontanemissions-Licht (202) zu dem ersten Isolator (243) auszugeben.

3. Vorrichtung nach Anspruch 1 oder 2, wobei die Steuereinrichtung (280) in Übertragungsverbindung mit der ersten Überwachungs-Fotodiode (260) steht und so konfiguriert ist, dass sie einen Leistungspegel des optischen signals als eine Funktion des erfassten Leistungspegels des verstärkten Spontanemissions-Lichts (202) bestimmt.

4. Vorrichtung nach Anspruch 1, 2 oder 3, wobei
eine zweite Überwachungs-Fotodiode (270), die ein ausgekoppeltes optisches Signal (204) erfasst, das von der Ausgangseinheit (250) emittiert wird, ohne zu dem einen Ende der Ausgangs-Lichtleitfaser (230) durchgelassen zu werden.

5. Vorrichtung nach Anspruch 2 oder 3, wobei die Ausgangseinheit (250) enthält:
ein zweites Kollimationslinsensystem (254), das das von der zweiten Stufe des optischen Halbleiterverstärkers (210) empfangene optische Signal kollimiert;
einen zweiten Isolator (253), der das von dem zweiten Kollimationslinsensystem (254) empfangene verstärkte optische Signal durchlässt, ein teilweise ausgekoppeltes optisches Signal (204) steuert, um es um einem vorgeschriebenen Winkel von einem Laufweg des verstärkten optischen Signals zu trennen, und das von dem Laufweg getrennte ausgekoppelte optische Signal (204) durchlässt;
ein zweites Sammellinsensystem (251), das so angeordnet ist, dass es das von dem zweiten Isolator (253) empfangene verstärkte optische Signal (203) auf ein Ende der Ausgangs-Lichtleitfaser (230) bündelt; und
ein zweites Glasfenster (252), das zwischen dem zweiten Isolator (2539 und dem zweiten Sammellinsensystem (252) angeordnet ist, um das kollimierte verstärkte optische Signal zu dem zweiten Sammellinsensystem (251) durchzulassen.

6. Vorrichtung nach Anspruch 1 oder 2, wobei die Ausgangseinheit enthält:
ein zweites Kollimationslinsensystem (254), das das von der zweiten Stufe des optischen Halbleiterverstärkers (210) empfangene verstärkte optische Signal kollimiert;
ein zweites Sammellinsensystem (251), das das durch das zweite Kollimationslinsensystem (254) kollimierte verstärkte optische Signal (203) auf ein Ende der Ausgangs-Lichtleitfaser (230) bündelt;
einen zweiten Isolator (253), der zwischen dem zweiten Kollimationslinsensystem (254) und dem zweiten Sammellinsensystem (251) angeordnet ist, um das von dem zweiten Kollimationslinsensystem (254) empfangene verstärkte optische Signal zu dem zweiten Sammellinsensystem (251) durchzulassen und von dem zweiten Sammellinsensystem (251) empfangene optische Signale zu sperren; und
ein zweites Glasfenster (252), das zwischen dem zweiten Isolator (253) und dem zweiten Sammellinsensystem (251) angeordnet ist, um das von dem zweiten Isolator 253) empfangene verstärkte optische Signal zu dem zweiten Sammellinsensystem (251) durchzulassen und ein teilweise ausgekoppeltes optisches Signal (204) zu reflektieren und es um einen vorgeschriebenen Winkel von dem Laufweg des verstärkten optischen Signals zu trennen.

7. Vorrichtung nach Anspruch 5 oder 6, wobei die zweite Überwachungs-Fotodiode (270) das getrennte, teilweise ausgekoppelte optische Signal (204) empfängt und einen Leistungspegel desselben erfasst.

8. Vorrichtung nach Anspruch 7, wobei die Steuereinrichtung (280) in Übertragungsverbindung mit der zweiten Überwachungs-Fotodiode (270) steht und so konfiguriert ist, dass sie einen Leistungspegel des von der zweiten Stufe des optischen Halbleiterverstärkers (210) empfangenen verstärkten optischen Signals auf Basis des erfassten Leistungspegels des getrennten, teilweise ausgekoppelten optischen Signals (204) bestimmt.

9. Vorrichtung nach Anspruch 8, wobei die Steuereinrichtung (210) so konfiguriert ist, dass sie als Funktion des erfassten Leistungspegels des verstärkten Spontanemissions-Lichtes (202) einen Leistungspegel des optischen Signals vor Verstärkung durch den optischen Halbleiterverstärker (210) bestimmt.

10. Vorrichtung nach einem der vorangehenden Ansprüche, wobei die Vorrichtung so konfiguriert ist, dass sie das Trennen des optischen Signals durch Brechen des optischen Signals durchführt.

11. Vorrichtung nach den Ansprüchen 3, 4, 8, 9 oder 10, wobei die Steuereinrichtung (280) in Übertragungsverbindung mit der ersten Überwachungs-Fotodiode (260), der Ausgangseinheit (250) und dem optischen Halbleiterverstärker (210) steht und so konfiguriert ist, dass sie einen Verstärkungspegel des optischen Halbeleiterverstärkers (210) reguliert.

## Revendications

1. Dispositif de module d'amplificateur (210) optique à semi-conducteur destiné à amplifier un signal (201) optique reçu à partir d'une fibre (220) optique d'entrée, et transmettre le signal (203) optique amplifié à une fibre (230) optique de sortie, comprenant :
un amplificateur (210) optique à semi-conducteur pour amplifier un signal (201) optique appliqué à sa propre première étape, fournissant en sortie le signal (203) optique amplifié à sa propre deuxième étape, et fournissant en sortie une lumière (202) d'Emission Spontanée Amplifiée à la première étape ;
un module (240) d'entrée ;
une première photodiode (260) de moniteur pour recevoir, et détecter un niveau de puissance de la lumière (202) d'Emission Spontanée Amplifiée passant à travers le premier (243) isolant ;
un module (250) de sortie pour faire converger le signal (203) optique amplifié reçu à partir de l'amplificateur (210) optique à semi-conducteur sur une extrémité de la fibre (230) optique de sortie ;
une deuxième photodiode (270) de moniteur pour détecter un signal (204) optique non couplé à partir du signal (203) optique amplifié ; et
un contrôleur (280) recevant des signaux à partir des photodiodes (260, 270) et produisant un signal de commande pour l'amplificateur (210) optique à semi-conducteur,
**caractérisé en ce que**
ledit module (240) d'entrée ayant un premier (243) isolant qui transmet un signal (201) optique d'entrée à la première étape de l'amplificateur (210) optique à semi-conducteur, commande la lumière (202) d'Emission Spontanée Amplifiée reçue à partir de la première étape de l'amplificateur (210) optique à semi-conducteur pour la séparer d'un trajet mobile du signal (201) optique d'entrée à un angle prescrit, et transmet la lumière (202) d'Emission Spontanée Amplifiée séparée du trajet mobile.

2. Dispositif selon la façon présentée dans la revendication 1, dans lequel le module (240) d'entrée comporte :
un premier système (241) d'objectif de collimation pour faire face à une extrémité de la fibre (220) optique d'entrée, et collimater le signal optique ;
une première fenêtre (242) de verre pour transmettre au premier (243) isolant le signal optique collimaté au premier système (241) d'objectif de collimation ; et
un premier système (244) d'objectif de convergence, disposé entre le premier (243) isolant et la première étape de l'amplificateur (210) optique à semi-conducteur, pour faire converger le signal optique reçu à partir du premier (243) isolant sur la première étape de l'amplificateur (210) optique à semi-conducteur, et fournir en sortie au premier (243) isolant la lumière (202) d'Emission Spontanée Amplifiée émise à partir de la première étape de l'amplificateur (210) optique à semi-conducteur.

3. Dispositif selon la façon présentée dans la revendication 1 ou 2, dans lequel ledit contrôleur (280) est relié de façon communicative à la première photodiode (260) de moniteur et configuré pour déterminer un niveau de puissance du signal optique comme une fonction du niveau de puissance mesuré de la lumière (202) d'Emission Spontanée Amplifiée.

4. Dispositif selon la façon présentée dans la revendication 1, 2 ou 3, dans lequel :
ladite deuxième photodiode (270) de moniteur mesurant un signal (204) optique non couplé qui est émis à partir du module (250) de sortie sans être transmis vers une extrémité de la fibre (230) optique de sortie.

5. Dispositif selon la façon présentée dans la revendication 1 ou 2, dans lequel le module (250) de sortie comporte :
un deuxième système (254) d'objectif de collimation pour collimater le signal optique amplifié reçu à partir de la deuxième étape de l'amplificateur (210) optique à semi-conducteur ;
un deuxième isolant (253) pour transmettre le signal optique amplifié reçu à partir du deuxième système (254) d'objectif de collimation, commandant un signal (204) optique non couplé partiellement pour le séparer d'un trajet mobile du signal optique amplifié à un angle prescrit, et transmettant le signal (204) optique non couplé séparé du trajet mobile ;
un deuxième système (251) d'objectif de convergence disposé pour faire converger le signal (203) optique amplifié reçu à partir du deuxième isolant (253) sur une extrémité de la fibre (230) optique de sortie ; et
une deuxième fenêtre (252) de verre disposée entre le deuxième isolant (253) et le deuxième système (252) d'objectif de convergence pour transmettre le signal optique amplifié collimaté au deuxième système (251) d'objectif de convergence.

6. Dispositif selon la façon présentée dans la revendication 1 ou 2, dans lequel le module de sortie comporte :
un deuxième système (254) d'objectif de collimation pour collimater le signal optique amplifié reçu à partir de la deuxième étape de l'amplificateur (210) optique à semi-conducteur ;
un deuxième système (251) d'objectif de convergence pour faire converger le signal (203) optique amplifié collimaté par le deuxième système (254) d'objectif de collimation sur une extrémité de la fibre (230) optique de sortie ;
un deuxième isolant (253) disposé entre le deuxième système (254) d'objectif de collimation et le deuxième système (251) d'objectif de convergence pour transmettre le signal optique amplifié reçu à partir du deuxième système (254) d'objectif de collimation au deuxième système (251) d'objectif de convergence, et couper les signaux optiques reçus à partir du deuxième système (251) d'objectif de convergence ; et
une deuxième fenêtre (252) de verre disposée entre le deuxième isolant (253) et le deuxième système (251) d'objectif de convergence, pour transmettre le signal optique amplifié reçu à partir du deuxième isolant (253) au deuxième système (251) d'objectif de convergence, et refléter un signal (204) optique non couplé partiellement pour le séparer du trajet mobile du signal optique amplifié à un angle prescrit.

7. Dispositif selon la façon présentée dans la revendication 5 ou 6, dans lequel ladite deuxième photodiode (270) de moniteur reçoit et mesure un niveau de puissance du signal optique (204) séparé et non couplé partiellement.

8. Dispositif selon la façon présentée dans la revendication 7, dans lequel ledit contrôleur (280) est relié de façon communicative à la deuxième photodiode (270) de moniteur et configuré pour déterminer un niveau de puissance du signal optique amplifié reçu à partir de la deuxième étape de l'amplificateur (210) optique à semi-conducteur basé sur le niveau de puissance mesuré du signal optique (204) séparé et couplé partiellement.

9. Dispositif selon la façon présentée dans la revendication 8, dans lequel le contrôleur (210) est configuré pour déterminer, comme fonction du niveau de puissance mesuré de la lumière (202) d'Emission Spontanée Amplifiée, un niveau de puissance du signal optique avant amplification par l'amplificateur (210) optique à semi-conducteur.

10. Dispositif selon la façon présentée dans l'une quelconque des précédentes revendications, dans lequel le dispositif est configuré pour effectuer la séparation du signal optique en réfractant le signal optique.

11. Dispositif selon la façon présentée dans les revendications 3, 4, 8, 9 ou 10, dans lequel le contrôleur (280) est en liaison communicative avec la première photodiode (260) de moniteur, le module (250) de sortie et l'amplificateur (210) optique à semi-conducteur et est configuré pour réguler un niveau d'amplification de l'amplificateur (210) optique à semi-conducteur.
